# EUROPEAN PATENT APPLICATION

(11) **EP 4 661 077 A1**
(43) Date of publication of application: **10.12.2025**
(21) Application number: 25178410.4
(22) Date of filing: 23.05.2025
(51) Int. Cl.: H01L 23/29, H01L 23/00, H01L 25/18, H01L 25/00, H01L 25/065

(54) **HIGH BANDWIDTH MEMORY TWIN TOWER PACKAGE**

(30) Priority: 04.06.2024 US 202463655850 P; 24.02.2025 US 202519061798
(71) Applicant: Samsung Electronics Co., Ltd., Suwon-si, Gyeonggi-do 16677 (KR)
(72) Inventor: YANG, Jin, San Jose, CA 95134 (US)
(74) Representative: Kuhnen & Wacker Patent- und Rechtsanwaltsbüro PartG mbB

(57) **Abstract**

A semiconductor device (1) and a method of manufacturing the semiconductor device (1) are provided. The semiconductor device (1) may include: a first semiconductor chip (10); at least one semiconductor chip stack (20) on a surface of the first semiconductor chip (10) in a first direction of the semiconductor device (1), the at least one semiconductor chip stack (20) configured to be electrically connected to the first semiconductor chip (10); and a dielectric (30) on the first semiconductor chip (10) in the first direction, and surrounding the at least one semiconductor chip stack (20) in at least one second direction of the semiconductor device (1), perpendicular to the first direction, wherein the at least one semiconductor chip stack (20) includes at least one second semiconductor chip (22L-22U).

## Description

### BACKGROUND

### 1. Field

Embodiments of the present disclosure relate to a semiconductor device and a method of manufacturing thereof, and, more particularly, a high bandwidth memory (HBM) multi-stack package and a method of manufacturing thereof.

### 2. Description of Related Art

In order to meet increasing demand of high performance computing and artificial intelligence (AI), core counts of modern processing units (PUs), such as central processing units (CPUs), graphics processing units (GPUs), accelerated processing units (APUs), etc., have been increasing to combat the slowdown of the end of Moore's Law.

However, due to the increasing core count, comparative embodiments have a "memory wall" problem.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

Embodiments of the present disclosure may address the above problems and/or other problems.

According to some example embodiments of the present disclosure, a semiconductor device may be provided and include: a first semiconductor chip; at least one semiconductor chip stack on a surface of the first semiconductor chip in a first direction of the semiconductor device, the at least one semiconductor chip stack configured to be electrically connected to the first semiconductor chip; and a dielectric on the first semiconductor chip in the first direction, and surrounding the at least one semiconductor chip stack in at least one second direction of the semiconductor device that is perpendicular to the first direction, wherein the at least one semiconductor chip stack includes at least one second semiconductor chip.

According to some example embodiments of the present disclosure, a method of manufacturing a semiconductor device may be provided. The method may include: forming a first layer of at least one semiconductor chip stack on a first semiconductor chip, in a first direction of the semiconductor device, by providing at least one second semiconductor chip on a surface of the first semiconductor chip as the first layer; providing a first layer of a dielectric on the surface of the first semiconductor chip such as to surround the first layer of the at least one semiconductor chip stack in at least one second direction of the semiconductor device, perpendicular to the first direction; providing at least one additional layer of the at least one semiconductor chip stack on the first layer of the at least one semiconductor chip stack in the first direction by stacking, in the first direction, at least one additional second semiconductor chip on the at least one second semiconductor chip constituting the first layer of the at least one semiconductor chip stack; and providing at least one additional layer of the dielectric on the first layer of the dielectric in the first direction, wherein the at least one semiconductor chip stack is configured to be electrically connected to the first semiconductor chip, and wherein the dielectric is on the first semiconductor chip in the first direction, and surrounds the at least one semiconductor chip stack in the at least one second direction.

According to some example embodiments of the present disclosure, a semiconductor memory system may be provided and include: a computing die; a plurality of semiconductor memory die stacks on a surface of the computing die in a first direction of the semiconductor memory system, the plurality of semiconductor memory die stacks configured to be electrically connected to the computing die; and a dielectric on the computing die in the first direction, and surrounding the plurality of semiconductor memory die stacks in at least one second direction of the semiconductor memory system that is perpendicular to the first direction, wherein of the plurality of semiconductor memory die stacks includes a plurality of memory dies that are stacked in the first direction. For example, the semiconductor memory system comprises a connection structure that connects memory dies among the plurality of semiconductor memory die stacks. For example, the connection structure comprises: an upper embedded metal; a lower embedded metal that is connected to the upper embedded metal; an upper dielectric layer; and a lower dielectric layer that is connected to the upper dielectric layer, and wherein the upper dielectric layer surrounds the upper embedded metal, and the lower dielectric layer surrounds the lower embedded metal. For example, the semiconductor memory system comprises a connection structure that connects a memory die stack, from among the plurality of semiconductor memory die stacks, to the computing die. For example, the connection structure comprises: an upper embedded metal; a lower embedded metal that is connected to the upper embedded metal; an upper dielectric layer; and a lower dielectric layer that is connected to the upper dielectric layer, and wherein the upper dielectric layer surrounds the upper embedded metal, and the lower dielectric layer surrounds the lower embedded metal.

### BRIEF DESCRIPTION OF DRAWINGS

Example embodiments of the present disclosure will be more clearly understood from the following detailed description taken in conjunction with the accompanying drawings in which:
FIG. 1 illustrates a schematic cross-sectional view of a semiconductor device according to a comparative embodiment;
FIG. 2 illustrates a schematic diagram for describing increased warpage caused by increasing semiconductor device size, according to comparative embodiments;
FIG. 3 illustrates a schematic cross-sectional view of a semiconductor device according to an example embodiment of the present disclosure;
FIG. 4 illustrates a schematic cross-sectional view of a portion A of the semiconductor device of FIG. 3, according to an example embodiment of the present disclosure;
FIG. 5 illustrates a flowchart for a method of manufacturing a semiconductor device according to an example embodiment of the present disclosure;
FIG. 6 illustrates an intermediate semiconductor device formed in an operation of the method of FIG. 5;
FIG. 7 illustrates an intermediate semiconductor device formed in an operation of the method of FIG. 5;
FIG. 8 illustrates an intermediate semiconductor device formed in an operation of the method of FIG. 5;
FIG. 9 illustrates an intermediate semiconductor device formed in an operation of the method of FIG. 5; and
FIG. 10 illustrates an intermediate semiconductor device formed in an operation of the method of FIG. 5.

### DETAILED DESCRIPTION

Embodiments of the present disclosure described herein are example embodiments, and thus, the present disclosure is not limited thereto, and may be realized in various other forms. Each of the embodiments provided in the following description is not excluded from being associated with one or more features of another embodiment also provided herein or not provided herein but consistent with the present disclosure. For example, even if matters described in a specific example embodiment are not described in a different example embodiment, the matters may be understood as being related to or combined with the different example embodiment, unless otherwise mentioned in descriptions thereof. In addition, it should be understood that all descriptions of principles, aspects, examples, and embodiments of the present disclosure are intended to encompass structural and functional equivalents thereof. In addition, these equivalents should be understood as including not only currently well-known equivalents but also equivalents to be developed in the future, that is, all devices that perform the same functions regardless of the structures thereof.

Unless otherwise defined, all terms, including technical and scientific terms, used herein have the same meaning as commonly understood by one of ordinary skill in the art to which the present disclosure pertains. Terms, such as those defined in commonly used dictionaries, are to be interpreted as having a meaning that is consistent with their meaning in the context of the relevant art, and are not to be interpreted in an idealized or overly formal sense unless expressly so defined herein. Additionally, the terms used herein are provided to describe non-limiting example embodiments of the present disclosure, and should not be construed as limiting the scope of the present disclosure. Unless expressly described to the contrary, terms used in the present disclosure may be interchangeable with other terms of the present disclosure.

It will be understood that when an element, component, layer, pattern, structure, region, or so on (hereinafter collectively "element") of a semiconductor device (or semiconductor package) is referred to as being "on," "connected to," or "coupled to" another element the semiconductor device, it can be directly on, connected to, or coupled to the other element or an intervening element(s) may be present. **In** contrast, when an element of a semiconductor device is referred to as being "directly on," "directly connected to," or "directly coupled to" another element of the semiconductor device, there are no intervening elements present. Like numerals refer to like elements throughout the present disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions here below, the "left" element and the "right" element may also be referred to as a "first" element or a "second" element, respectively, as long as their structural relationship is clearly understood in the context of the descriptions. Similarly, the terms a "lower" element and an "upper" element may be respectively referred to as a "first" element and a "second" element to distinguish the two elements.

It will be understood that, although the terms "first," "second," "third," "fourth," "fifth," "sixth," etc., may be used herein to describe various elements, these elements should not be limited by these terms. These terms are only used to distinguish one element from another element. Thus, a first element discussed below could be termed a second element without departing from the scope of the present disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" or "equal" is used to compare a dimension of two or more elements, the term may cover a "substantially same" or "substantially equal" dimension.

It will be also understood that, when a method of manufacturing an apparatus or structure is described as including a plurality of steps or operations, a certain step or operation described as being performed later than another step or operation may be performed prior to or at the same time as the other step or operation unless the other step or operation is described as necessarily being performed prior to the step or operation. Further, the method may include additional steps or operations not mentioned in the description.

Many example embodiments are described herein with reference to cross-sectional views that are schematic illustrations of the embodiments (and intermediate structures). As such, variations from the shapes of the illustrations as a result of, for example, manufacturing techniques and/or tolerances are to be expected. Thus, the embodiments should not be construed as limited to the particular shapes of regions illustrated herein, and are to include deviations in shapes that result from, for example, manufacturing. Various regions illustrated in the figures are schematic in nature and their shapes may not be intended to illustrate the actual shape of a region of a device and are not intended to limit the scope of the present disclosure. Further, in the drawings, the sizes and relative sizes of layers and regions may be exaggerated for clarity.

For the sake of brevity, conventional elements, structures, or layers included in a semiconductor package including a connection pad, an adhesive layer, an isolation layer, a barrier metal pattern, a seed layer, etc. may or may not be described in detail herein. For example, descriptions of certain connection pads of a semiconductor chip connected to solder balls or bumps in a semiconductor package may be omitted herein when these structural elements are not related to certain features of the embodiments. Also, descriptions of materials forming well-known structural elements may be omitted herein when those materials are not relevant to certain features of the embodiments. Herein, the term "connection" between two structures or elements may refer to an electrical connection therebetween. For example, a connection between semiconductor chips, semiconductor packages, and/or semiconductor devices may refer to an electrical connection of a corresponding two or more elements to each other. The terms "coupled" and "connected" may have the same meaning and may be used interchangeably herein. Further, the term "isolation" between two structures or elements pertains to electrical insulation or separation therebetween. For example, isolation of wiring patterns from each other may mean that the wiring patterns are not electrically connected to each other.

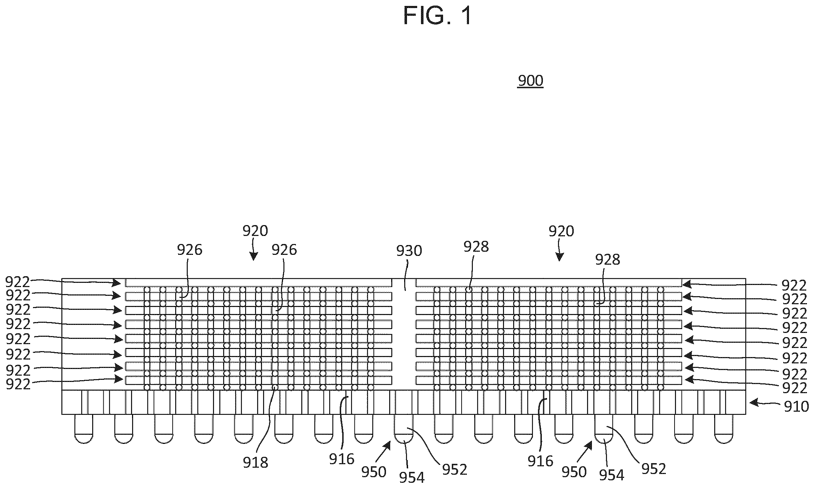

Hereinafter, various example embodiments of the present disclosure are described with reference to FIGS. 1-10.

In order to meet increasing demand of high performance computing and AI, core counts of modern PUs, such as CPUs, GPUs, APUs, etc., have been increasing to combat the slowdown of the end of Moore's Law. For example, the core count for modern CPUs has recently exceeded 64 cores (66 printed cores). Further to meet the needs of modern AI and gaming usage, today's GPU chips have over thousands of GPU cores. However, with increasing CPU/GPU core counts, a new problem of a "memory wall" has become a bottleneck.

The memory wall describes implications of the processor/memory performance gap that has grown steadily over the last several decades. If memory latency and a bandwidth of a memory become insufficient to provide processors with enough instructions and data to continue computation, processors will increasingly be stalled waiting on the memory. The trend of placing more and more cores on chips exacerbates the situation, since each core may include a relatively narrower channel to shared memory resources. In today's compute architecture, processors fetch data from a hierarchy of a memory, from a fast but low capacity L1 cache, to an L2 cache, to an L3 cache, and then to a relatively slower but high capacity dynamic random access memory (DRAM). In order to overcome this issue, a high bandwidth memory (HBM) has been introduced and integrated directly with computing engines using advanced packaging, including 2.5D and 3D integrated circuit (IC) packages. By placing an HBM closer to processor cores, it helps reduce latency and increase storage capacity at the same time. However, there is a latency to transfer a large amount of data between the processor cores and the HBM through a silicon interposer or an active silicon. Meanwhile, a standard HBM, which follows the Joint Electron Device Engineering Council (JEDEC) standard, has required increasing power. For example, High Bandwidth Memory 3 (HBM3), a type of memory that is compliant with the JESD238 standard as of submission of the present application, may have 12 layers of DRAM that include 24 gigabytes (GB) of memory capacity, and may have a power requirement of 30 Watts (W) at a data transfer speed of 6.4 gigabits per second (Gb/s).

Development of artificial intellgience (AI)s, especially large language models (LLMs), imposes challenges to a modern compute architecture, memory technology, and its integration with a system on chip (SoC) for meeting expotentially increasing computing needs of LLMs used in AI training, including generative pre-trained transformer (GPT) and others. New computing, memory architecture, and integration are needed for meeting this AI/LLM demand.

Additionally, due to technological changes caused by the development of AI, there is a need to develop a package/chip architecture that integrates computing dies (e.g., logic dies) and memory dies (e.g., DRAM) with more memories as close as possible to the computing dies for an increased memory bandwidth and capacity. Such a need is particularly relevant to high performance computing (HPC) and data centers.

A DRAM dual in-line memory module (DIMM) may be used with a CPU (or GPU) on a printed circuit board (PCB). The DRAM DIMM may provide a required memory for the CPU (or GPU). The DRAM DIMM may be inserted into a PCIe slot to establish electrical connections between the CPU (or GPU) and the DRAM DIMMs. The DRAM DIMMs may be placed away from the CPU (or GPU) by about a centimeter(s) (cm) distance in a standard configuration.

HBM technology may be integrated with computing chips into one package to provide a desired memory bandwidth and capacity in observance of memory wall challenges. This type of integration may be implemented via 2.5D IC packages using a silicon interposer. In an architecture, a package may include one lane of HBM chips (e.g., HBM2, HBM3, HBM4, and/or future HBM types) on each side of computing chips (e.g., GPU or other application-specific integrated circuit (ASIC)). For example, a package may include six stacks of HBM3 on a chip and, more specifically, with three stacks of HBM3 on each side of one central GPU. This chip may be implemented using a 2.5D package that includes a silicon interposer.

A package may integrate DRAMs directly on one computing die using an advanced silicon node. In this package, an HBM controller die in a standard HBM architecture is replaced with a base computing die fabricated using an advanced silicon node. Compared to the standard HBM, 40% power may be saved by introducing a base die fabricated with an advanced node (e.g., 4 nm or 3 nm) to replace the standard HBM controller die, which may be fabricated using an older silicon node (e.g., 14 nm). In order to boost overall computing performance, power of the base computing die can go up to hundreds of watts (e.g., 500 W). In an embodiment, a package may have a computing die and a single DRAM stack on the computing die, which constrains power of the base computing die, thereby constraining performance. Accordingly, there is a need to overcome this issue.

In an attempt to reduce performance constraints of the computing die, a plurality of DRAM stacks may be provided on the computing die. For example, in an embodiment, as shown in FIG. 1, a semiconductor device 900 may be provided. The semiconductor device 900 may include a base die 910, a plurality of semiconductor chip stacks 920 on a top surface of the base die 910, and an over-molding 930 that may encapsulate the semiconductor chip stacks 920 on the base die 910. Bottom interconnects 950 (e.g., µbumps) may also be provided on a bottom surface of the base die 910.

The base die 910 may be a semiconductor chip and may be made of silicon. The base die 910 may be a computing base die, which may be different from a buffer die used in a JEDEC standard HBM product. For example, a buffer die may be a die that is dedicated to performing a buffer function. For example, a buffer die, in some example embodiments, may manage data flow between stacked memory dies (e.g., semiconductor chip stacks 920) and a processor of an external system. The buffer die may have logic circuity configured to perform a buffer function (e.g., interface with the external system while also controlling data transfer within the HBM product (e.g., the semiconductor device 900)).

The plurality of semiconductor chip stacks 920 may each include a plurality of semiconductor chips 922 that are stacked on each other, on the top surface of the base die 910. The plurality of semiconductor chips 922 may be made of silicon. The plurality of semiconductor chips 922 may be DRAM core dies, respectively, that are stacked on each other. The over-molding 930 may surround each of the semiconductor chip stacks 920 in at least horizontal directions for providing structural integrity and encapsulating the DRAM core dies. For example, the over-molding 930 may be between two or more of the semiconductor chip stacks 920, between the semiconductor chip stacks 920 and the base die 910, and between the semiconductor chips 922 of the semiconductor chip stacks 920. The over-molding 930 may be provided to encapsulate the semiconductor chip stacks 920 in a fabrication process of the semiconductor device 900. The over-molding 930 may be formed of at least one epoxy molding compound (EMC).

The semiconductor chips 922 may be electrically connected together by connection structures 926. For example, the connection structures 926 may include through-silicon vias (TSVs) that penetrate through the semiconductor chips 922. The semiconductor device 900 may further include microbumps (µbumps) 928 that are between each pair of vertically adjacent ones of the semiconductor chips 922 and electrically connect together the connection structures 926 (e.g., the TSVs) of the pair of vertically adjacent ones of the semiconductor chips 922. The µbumps 928 may be horizontally surrounded by underfill and/or the over-molding 930. The µbumps 928 may include, for example, copper and a metal solder such as, for example, copper-tin-copper-SnAg solder or nickel-gold-solder.

The base die 910 may include connection structures 916. The connection structures 916 may electrically connect components (e.g., the semiconductor chips 922) to the base die 910 and/or may electrically connect the components together through the base die 910. For example, the connection structures 916 may include TSVs that penetrate through the semiconductor chips 922. The connection structures 916 (e.g., the TSVs) may be electrically connected to the semiconductor chips 922. For example, µbumps 918 may be provided between the lowermost ones of the semiconductor chips 922 of the semiconductor chip stacks 920 and the base die 910, and may electrically connect together portions of the connection structures 926 that are within the lowermost ones of the semiconductor chips 922 to the connection structures 916 of the base die 910. The µbumps 918 may include, for example, copper and a metal solder such as, for example, copper-tin-copper-SnAg solder or nickel-gold-solder.

The bottom interconnects 950 provided on the bottom surface of the base die 910 may be electrically connected to the connection structures 916. The bottom interconnects 950 may be configured to electrically connect components underneath the semiconductor device 900 to the base die 910 and/or to one or more of the semiconductor chips 922 of the semiconductor chip stacks 920 through the connection structures 916 of the base die 910. The bottom interconnects 950 may be, for example, µbumps. The µbumps may include, for example, a copper body 952 and a metal solder 954 such as, for example, copper-tin-copper-SnAg solder or nickel-gold-solder.

As described above, each of the base die 910 and the semiconductor chips 922 may include silicon, and the over-molding 930 may include EMC. The CTE of silicon is about 2.6-2.8 ppm/°C. However, the CTE of EMC is normally larger than 7 ppm/°C. Also, the CTE of SiCN is about 3.2 ppm/°C. In embodiments, since there is a large coefficient of thermal expansion (CTE) mismatch between EMC and silicon, there may be increased warpage when a size of the base die 910 (or the size of a semiconductor device including the base die 910) increases.

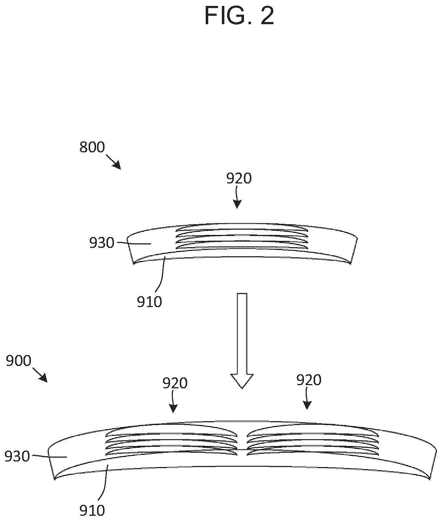

For example, with reference to FIG. 2, in comparison to a semiconductor device 800 of an embodiment that includes only a single one of the semiconductor chip stacks 920, warpage (e.g., of the over-molding 930, the semiconductor chips 922, and/or the base die 910) may be more than doubled with the semiconductor device 900 of the embodiment due to an increasing aspect ratio of the base die 910, adding risk in a manufacturing process of the semiconductor device 900.

In order to overcome limitations of the embodiments described above and/or other problems, some example embodiments of the present disclosure may include a different class of product, called an HBM multi-stack (also referred to as an HBM multi-stack package), with a new chip/package architecture and a corresponding manufacturing process thereof.

According to some example embodiments of the present disclosure, an HBM multi-stack may be fabricated by assembling clusters of stacked DRAM dies on top of a base computing die and encapsulated using dielectric material with relatively low CTE, like SiCN. The base computing die may be fabricated via an advanced silicon node. The HBM multi-stack may be used as an individual memory component and may be integrated into one package (e.g., chip) with a computing die, an input/out (I/O) die, a network chip, etc., either on a same organic substrate, or on a same silicon interposer, or connected via an embedded silicon bridge or other package platforms. The HBM multi-stack may serve as a standard memory component with a computing die via a short electrical connection path.

The HBM multi-stack may be used in banks or an array to integrate with a computing die (engine) and other chiplets into one chip or package to provide memory capacity, bandwidth, and low latency to an entire chip and card (e.g., an accelerator card).

The HBM multi-stack may have a die-2-die (D2D) layer in a base computing die to realize communication between stacked DRAM and a computing die(s).

Semiconductor devices (e.g., HBM multi-stack packages) according to some example embodiments of the present disclosure may enable the different class of product to meet increasing demands of computing and memory for AI, HPC, and data centers.

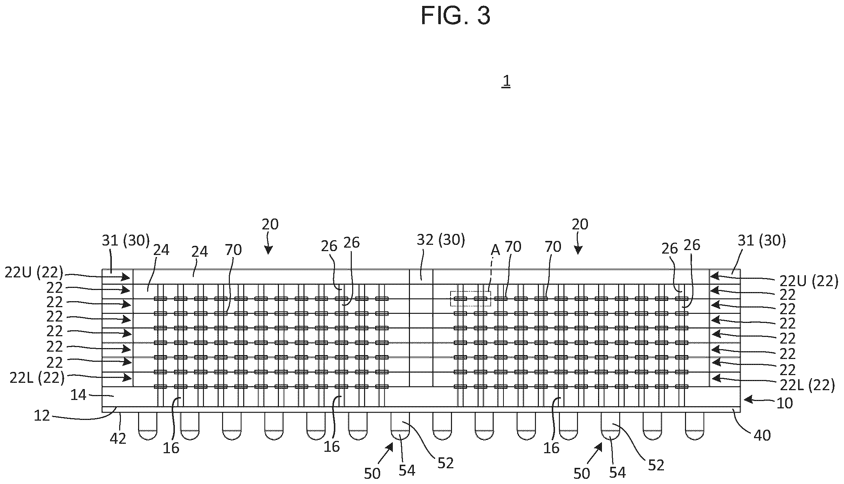

An example of the HBM multi-stack package according to an example embodiment of the present disclosure is a semiconductor device 1 shown in FIG. 3-4.

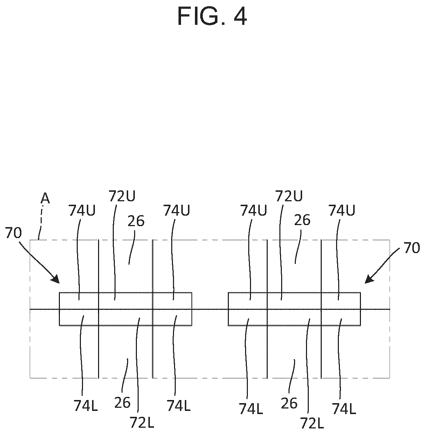

FIG. 3 illustrates a schematic cross-sectional view of the semiconductor device 1 according to an example embodiment of the present disclosure. FIG. 4 illustrates a schematic cross-sectional view of a portion A of the semiconductor device 1 of FIG. 3, according to an example embodiment of the present disclosure.

With reference to FIGS. 3-4, the semiconductor device 1 may be, for example, a semiconductor memory device (or a semiconductor memory package). For example, the semiconductor device 1 may be an HBM device that has a higher bandwidth than standard HBMs and DRAM DIMMs. For example, the semiconductor device 1 may be a different type of HBM (e.g., an HBM multi-stack).

The semiconductor device 1 may include a base die 10, a plurality of semiconductor chip stacks 20 on a top surface of the base die 10, and a dielectric 30 that may surround (e.g., encapsulate) the semiconductor chip stacks 20 on the base die 10. Bottom interconnects 50 (e.g., µbumps) may also be provided on a bottom surface 12 of the base die 10. According to some example embodiments of the present disclosure, one or more redistribution layers (RDLs) 40 may be provided between the base die 10 and the bottom interconnects 50. For example, the bottom interconnects 50 may be provided on a bottom surface 42 of the one or more RDLs 40.

The base die 10 may be a semiconductor chip. For example, the base die 10 may be a computing device (e.g., a computing die such as, for example, a computing die), which may be also referred to as a logic die (or device), and may be different from a buffer die used in a JEDEC standard HBM product. For example, in some example embodiments of the present disclosure, the base die 10 may be configured to perform a logic function and a buffer function. The logic function may be a user designed logic function including, for example, a computing function and/or other types of functions that users intend to be performed. The logic function may be implemented by, for example, an advanced node (e.g., a 7 nm, 4nm, or 2 nm silicon (Si) node) of the base die 10. The buffer function may include, for example, managing data flow between stacked memory dies (e.g., semiconductor chip stacks 920) and/or a processor of an external system, "reading" from and "writing" to memory (e.g., the semiconductor chip stacks 920), and/or communicating with other dies (e.g., the semiconductor chip stacks 920) of the semiconductor device 1. The base die 10 may have logic circuity configured to perform the buffer function (e.g., interface with the external system and/or control data transfer within the semiconductor device 1 (e.g., an HBM product)). The logic circuitry for implementing the buffer function may include, for example, matured silicon (Si) nodes (e.g., 22 nm node, etc.). According to some example embodiments, the buffer function may be standardized rather than being specific to a particularly user. By including the base die 10 configured to perform both the logic function and the buffer function, the semiconductor device 1 may not include a separate, dedicated buffer die, and may be referred to as a "bufferless HBM." For example, the semiconductor device 1 may be configured as a custom HBM (e.g., an HBM multi-stack package).

According to some example embodiments of the present disclosure, the base die 10 may be configured to, for example, distribute input and output (I/O) signals with components connected thereto (e.g., the semiconductor chip stacks 20 and/or other components). The base die 10 may include a body 14 that is made of silicon.

The plurality of semiconductor chip stacks 20 may be separated from each other in at least one horizontal direction. As shown in the cross-sectional view of FIG. 2, two semiconductor chip stacks 20 are provided and separated from each other in a first horizontal direction. However, embodiments of the present disclosure are not limited thereto. For example, three or more semiconductor chip stacks 20 may be provided on the top surface of the base die 10 and may be separated from each other in the first horizontal direction. Alternatively or additionally, two or more semiconductor chip stacks 20, on the top surface of the base die 10, may be separated from each other in a second horizontal direction that crosses (e.g., is perpendicular to) the first horizontal direction. According to some example embodiments of the present disclosure, a plurality of the semiconductor chip stacks 20 may be provided in an array pattern on the top surface of the base die 10.

Each of the semiconductor chip stacks 20 may each include a plurality of semiconductor chips 22 that are stacked on each other in the vertical direction, on the top surface of the base die 10. The semiconductor chips 22 may each be, for example, a semiconductor memory device (e.g., a memory die (or device) such as, for example, a DRAM die). In a case where the semiconductor device 1 is a custom HBM (e.g., an HBM multi-stack package), the semiconductor chips 22 may be referred to as HBM cores (or dies). The semiconductor chips 22 may be obtained by singulating the semiconductor chips 22 from a same die and/or different dies.

In each of the semiconductor chip stacks 20, a lowermost semiconductor chip 22L, among the semiconductor chips 22, may be provided on the top surface of the base die 10, and then other semiconductor ships 22 may be stacked thereon in the vertical direction. As shown in the cross-section view of FIG. 2, each of the semiconductor chip stacks 20 may include eight semiconductor chips 22. However, embodiments of the present disclosure are not limited thereto. For example, each of the semiconductor chip stacks 20 may include 4, 8, 12, etc., semiconductor chips that are stacked on each other.

The semiconductor chips 22 may respectively include bodies 24 that are made of silicon. As shown in FIG. 3, the semiconductor chips 22 (e.g., the bodies 24) may have a same shape as each other. For example, each of the semiconductor chips 22 (e.g., the bodies 24) may have a same thickness in the vertical direction and a same width in at least one horizontal direction as each other. For example, a maximum thickness of each of the semiconductor chips 22 (e.g., the bodies 24) may be 50 µm or less, or 20 µm or less. However, embodiments of the present disclosure are not limited thereto. For example, at least one of the semiconductor chips 22 (e.g., the bodies 24) may have a different thickness and/or width from at least one other of the semiconductor chips 22 in the same semiconductor chip stack 20 and/or in a different semiconductor chip stack 20.

According to some example embodiments of the present disclosure, side surfaces of the semiconductor chips 22 of a single one of the semiconductor chip stacks 20 may be coplanar with each other. However, embodiments of the present disclosure are not limited thereto.

The plurality of semiconductor chips 22 may be memory core dies (e.g., DRAM core dies), respectively, that are stacked on each other in the vertical direction. In other words, each of the semiconductor chip stacks 20 may include a plurality of memory core dies (e.g., DRAM core dies) that are stacked on each other in the vertical direction. According to some example embodiments of the present disclosure, the semiconductor chips 22 that are stacked may be in direct contact with each other.

The dielectric 30 may surround each of the semiconductor chip stacks 20 in at least one horizontal direction. For example, two or more (including all) side surfaces of the semiconductor chip stacks 20 may be surrounded by the dielectric 30 in at least one horizontal direction (e.g., the first horizontal direction and/or the second horizontal direction). For example, the dielectric 30 may directly contact the two or more (including all) side surfaces of the semiconductor chip stacks 20 in at least one horizontal direction (e.g., the first horizontal direction and/or the second horizontal direction). The dielectric 30 may be provided on the top surface of the base die 10 and may extend vertically such as to cover the two or more side surfaces of each of the semiconductor chips 22 of the semiconductor chip stacks 20. For example, the dielectric 30 may be in direct contact with top surface of the base die 10 and may be in direct contact with the two or more side surfaces of each of the semiconductor chips 22 of the semiconductor chip stacks 20. According to some example embodiments of the present disclosure, the dielectric 30 may not be provided between the semiconductor chips 22 of a single one of the semiconductor chip stacks 20 and/or may not be provided between the lowermost semiconductor chips 22L and the base die 10. For example, the semiconductor chips 22 of the single one of the semiconductor chip stacks 20 may be in direct contact with each other and/or the lowermost semiconductor chips 22L and the base die 10 may be in direct contact with each other.

The dielectric 30 may have a low CTE. For example, the CTE of the dielectric 30 may be 4 ppm/°C or lower. The dielectric 30 may be configured to protect the semiconductor chip stacks 20 (e.g., from moisture) and/or provide additional stiffness to the semiconductor device 1. The dielectric 30 may be made of, for example, silicon dioxide (SiO₂), silicon carbon nitride (SiCN), silicon nitride (SiN), etc. The dielectric 30 may include first portions 31 and second portions 32.

The first portions 31 may be provided at outer sides of the semiconductor chip stacks 20 towards the outer sides of the semiconductor device 1 in at least one horizontal direction (e.g., the first horizontal direction and/or the second horizontal direction). For example, as shown in FIG. 3, one vertically stacked group of first portions 31 is provided at a left side of a leftmost one of the semiconductor chip stacks 20, and another vertically stacked group of first portions 31 is provided at a right side of a rightmost one of the semiconductor chip stacks 20. The first portions 31 provided at the left side of the leftmost one of the semiconductor chip stacks 20 may be in direct contact with the left side surfaces of each of the semiconductor chips 22 in the leftmost one of the semiconductor chip stacks 20, respectively, and the first portions 31 provided at the right side of the rightmost one of the semiconductor chip stacks 20 may be in direct contact with the right side surfaces of each of the semiconductor chips 22 in the rightmost one of the semiconductor chip stacks 20, respectively. The first portions 31 may partially or completely cover the outer side surfaces of the semiconductor chip stacks 20 that face towards an exterior of the semiconductor device 1 in at least one horizontal direction (e.g., the first horizontal direction and/or the second horizontal direction).

A total number of the first portions 31 in each vertically stacked group may be the same as a total number of the semiconductor chips 22 in each semiconductor chip stack 20. For example, as shown in FIG. 3, the total number of the first portions 31 in each vertically stacked group is eight, and the total number of the semiconductor chips 22 in each semiconductor chip stack 20 is eight. However, embodiments of the present disclosure are not limited thereto. For example, the total number of the semiconductor chips 22 in each semiconductor chip stack 20 may be 4, 8, 12, etc. According to some example embodiments of the present disclosure, a boundary between adjacent ones of the first portions 31 may or may not be visually discernable.

A thickness of each first portion 31 in the vertical direction may be the same as the thickness, in the vertical direction, of the semiconductor chip 22 that is in direct contact therewith. For example, a thickness of each of the first portions 31 may be about 50 µm or less, or about 20 µm or less. Also, an upper surface of each first portion 31 may be coplanar with the upper surface of the semiconductor chip 22 that is in direct contact therewith, and a lower surface of each first portion 31 may be coplanar with the lower surface of the semiconductor chip 22 that is in direct contact therewith. For example, an outer side surface of the lowermost semiconductor chip 22L may be in direct contact with one first portion 31, such first portion 31 may have a same thickness as a thickness of the lowermost semiconductor chip 22L, and an upper surface and a lower surface of such first portion 31 may be coplanar with the upper surface and the lower surface of the lowermost semiconductor chip 22L, respectively. Additionally, upper surfaces of the uppermost ones of the first portions 31 may be coplanar with uppermost surfaces of the uppermost semiconductor chips 22U among the semiconductor chips 22. The upper surfaces of the uppermost ones of the first portions 31 and the uppermost surfaces of the uppermost semiconductor chips 22U may define at least a portion of an upper surface of the semiconductor device 1.

The second portions 32 may be provided between inner side surfaces of the semiconductor chip stacks 20 that face towards each other in at least one horizontal direction (e.g., the first horizontal direction and/or the second horizontal direction), and may partially or completely cover the inner side surfaces of the semiconductor chip stacks 20 that face towards each other in at least one horizontal direction (e.g., the first horizontal direction and/or the second horizontal direction). For example, as shown in FIG. 3, the second portions 32 are vertically stacked between the semiconductor chip stacks 20. The second portions 32 may be in direct contact with the right side surfaces of each of the semiconductor chips 22 in the leftmost one of the semiconductor chip stacks 20, respectively, and may be in direct contact with the left side surfaces of each of the semiconductor chips 22 in the rightmost one of the semiconductor chip stacks 20, respectively.

A total number of the second portions 32 may be the same as a total number of the semiconductor chips 22 in each semiconductor chip stack 20. For example, as shown in FIG. 3, the total number of the second portions 32 may be eight, and the total number of the semiconductor chips 22 in each semiconductor chip stack 20 may be eight. However, embodiments of the present disclosure are not limited thereto.

A thickness of each second portion 32 in the vertical direction may be the same as the thickness, in the vertical direction, of the semiconductor chips 22 that are in direct contact therewith. For example, a thickness of each of the second portions 21 may be 50 µm or less, or 20 µm or less. Also, an upper surface of each second portion 32 may be coplanar with the upper surfaces of the semiconductor chips 22 that are in direct contact therewith, and a lower surface of each first portion 31 may be coplanar with the lower surfaces of the semiconductor chips 22 that are in direct contact therewith. For example, inner side surfaces of the lowermost semiconductor chips 22L may be in direct contact with one second portion 32, such second portion 32 may have a same thickness as a thickness of the lowermost semiconductor chips 22L, and an upper surface and a lower surface of such second portion 32 may be coplanar with the upper surfaces and the lower surfaces of the lowermost semiconductor chips 22L, respectively. Additionally, an upper surface of the uppermost ones of the second portions 32 may be coplanar with uppermost surfaces of the uppermost semiconductor chips 22U among the semiconductor chips 22. The upper surface of the uppermost one of the second portions 32 and the uppermost surfaces of the uppermost semiconductor chips 22U may define at least a portion of the upper surface of the semiconductor device 1.

A total number of the second portions 32 may be the same as a total number of the semiconductor chips 22 in each semiconductor chip stack 20. For example, as shown in FIG. 3, the total number of the second portions 32 may be eight, and the total number of the semiconductor chips 22 in each semiconductor chip stack 20 may be eight. However, embodiments of the present disclosure are not limited thereto. According to some example embodiments of the present disclosure, a boundary between adjacent ones of the second portions 32 may or may not be visually discernable.

According to some example embodiments of the present disclosure, the first portions 31 and the second portion 32 that are at a same vertical level as each other may be referred to as a same one layer of the dielectric 30. Also, semiconductor chips 22 from among the plurality of semiconductor chip stacks 20 that are at a same vertical level as each other may be referred to as a same one layer of the semiconductor chip stacks 20. Accordingly, for example, a plurality of layers of the dielectric 30 and a plurality of layers of the semiconductor chip stacks 20 may be provided so as to respectively correspond to each.

According to some example embodiments, the first portions 31 and the second portions 32 are made of a same dielectric material as each other and/or may be contiguous with each other. The first portions 31 and the second portions 32 may be configured to surround each layer of the semiconductor chip stacks 20 (e.g., each of the semiconductor chips 22).

The semiconductor chips 22 may each include connection structures 26 that electrically connect components of the semiconductor chip 22 together, electrically connect other components (e.g., one or more other semiconductor chips 22, the base die 10, and/or one or more components exterior to the semiconductor device 1) to the semiconductor chip 22, and/or electrically connect the other components together through the semiconductor chip 22. For example, the connection structures 26 may include interconnects and/or TSVs that extend horizontally and/or vertically within a respective one of the semiconductor chips 22 to form electrical connections. For example, the TSVs of the connection structure 26 may extend substantially from a top surface substantially to a bottom surface of a respective one of the semiconductor chips 22. According to some example embodiments of the present disclosure, the uppermost semiconductor chip 22U may not include the connection structures 26. However, embodiments of the present disclosure are not limited thereto, and the uppermost semiconductor chip 22U may include the connection structures 26.

The base die 10 may include connection structures 16 that electrically connect components of the base die 10 together, electrically connect other components (e.g., one or more semiconductor chips 22 and/or one or more components exterior to the semiconductor device 1) to the base die 10), and/or electrically connect the other components together through the base die 10. For example, the connection structures 16 may include interconnects and/or TSVs that extend horizontally and/or vertically within the base die 10 to form electrical connections. For example, the TSVs of the connection structure 16 may extend substantially from the top surface substantially to the bottom surface of the base die 10.

The bottom interconnects 50 provided on the bottom surface 12 of the base die 10 (or the bottom surface 42 of the one or more RDL layers 40) may be electrically connected to the connection structures 16. The bottom interconnects 50 may be configured to electrically connect components underneath the semiconductor device 1 to the base die 10 and/or to one or more of the semiconductor chips 22 of the semiconductor chip stacks 20 through the connection structures 16 of the base die 10. The bottom interconnects 50 may be, for example, µbumps. The µbumps may include, for example, a copper body 52 and a metal solder 54 such as, for example, copper-tin-copper-SnAg solder or nickel-gold-solder.

According to some example embodiments of the present disclosure, and unlike the embodiment described with reference to FIG. 1, µbumps between semiconductor chips (or dies) and underfill provided with the µbumps may be omitted. For example, die to die stacking and bonding between the semiconductor chips 22 (e.g., DRAM core dies) and between the semiconductor chips 22 and the base die 10 (e.g., a computing die) may be performed using hybrid bonding (e.g., using a connection structure). Hybrid bonding may refer to a permanent bond that combines a dielectric bond (e.g., SiOx) with embedded metal (e.g., Cu) to form interconnections. For example, the hybrid bonding may include copper-to-copper direct bonding and dielectric direct bonding. For example, a plurality of hybrid bonding structures 70 may be provided between each pair of vertically adjacent ones of the semiconductor chips 22, and between the lowermost semiconductor chips 22L and the base die 10.

With reference to FIG. 4, each of the hybrid bonding structures 70 may include an upper embedded metal 72U (e.g., a metal pad), an upper dielectric layer 74U, a lower embedded metal 72L (e.g., a metal pad), and a lower dielectric layer 74L. The upper embedded metal 72U and the lower embedded metal 72L may include, for example, copper. The upper dielectric layer 74U and the lower dielectric layer 74L may include, for example, SiO₂, SiCN, SiN, etc. The upper embedded metal 72U may be embedded in the upper dielectric layer 74U such as to be surrounded by the upper dielectric layer 74U in horizontal directions. The lower embedded metal 72L may be embedded in the lower dielectric layer 74L such as to be surrounded by the lower dielectric layer 74L in horizontal directions. The upper embedded metal 72U and the upper dielectric layer 74U may be recessed in a lower surface of an upper component (e.g., a semiconductor chip 22) to be bonded, such that lower surfaces of the upper embedded metal 72U and the upper dielectric layer 74U may be coplanar with the lower surface of the upper component (e.g., the semiconductor chip 22). The lower embedded metal 72L and the lower dielectric layer 74L may be recessed in an upper surface of a lower component (e.g., a semiconductor chip 22 or the base die 10) to be bonded, such that upper surfaces of the lower embedded metal 72L and the lower dielectric layer 74L may be coplanar with the upper surface of the lower component (e.g., the semiconductor chip 22 or the base die 10). The lower surface of the upper embedded metal 72U may be in direct contact with and bonded to the upper surface of the lower embedded metal 72L. The lower surface of the upper dielectric layer 74U may be in direct contact with and bonded to the upper surface of the lower dielectric layer 74L. According to some example embodiments of the present discourse, each of the upper embedded metal 72U, the upper dielectric layer 74U, the lower embedded metal 72L, and the lower dielectric layer 74L may have a thickness in a vertical direction that is 1 µm or less, but embodiments of the present disclosure are not limited thereto.

According to some example embodiments of the present disclosure, the upper embedded metal 72U and the lower embedded metal 72L may be on upper and lower surfaces of respective components (e.g., the semiconductor chips 22 and/or the base die 10), and the upper dielectric layer 74U and the lower dielectric layer 74L may extend along upper and lower surfaces of the respective components (e.g., the semiconductor chips 22 and/or the base die 10) such that some or all portions of the upper and lower surfaces, that are not covered by the upper embedded metal 72U and the lower embedded metal 72L, are covered by the upper dielectric layer 74U and the lower dielectric layer 74L, respectively. For example, a single contiguous layer of the upper dielectric layer 74U and a single contiguous layer of the lower dielectric layer 74L may be provided along the upper and lower surfaces, respectively, where the upper embedded metal 72U and the lower embedded metal 72L are not provided. For example, each of the hybrid bonding structures 70 at a same vertical level in a same semiconductor chip stack 20 or between the semiconductor chip stacks 20 and the base die 10 may share a same contiguous portion of the upper dielectric layer 74U and a same contiguous portion of the lower dielectric layer 74L.

Through the hybrid bonding process, the semiconductor chips 22 and/or the lowermost semiconductor chip 22L and the base die 10 may be directly bonded together via the hybrid bonding structures 70, and the semiconductor chips 22 and/or the lowermost semiconductor chip 22L and the base die 10 may be electrically connected together via the upper embedded metal 72U and the lower embedded metal 72L of the hybrid bonding structures 70. For example, the upper embedded metal 72U may be in direct contact with and electrically connected to at least one of the connection structures 26 of the upper component (e.g., the semiconductor chip 22), and the lower embedded metal 72L may be in direct contact with and electrically connected to at least one of the connection structures (e.g., the connection structures 26 or the connection structures 16) of the lower component (e.g., the semiconductor chip 22 or the base die 10).

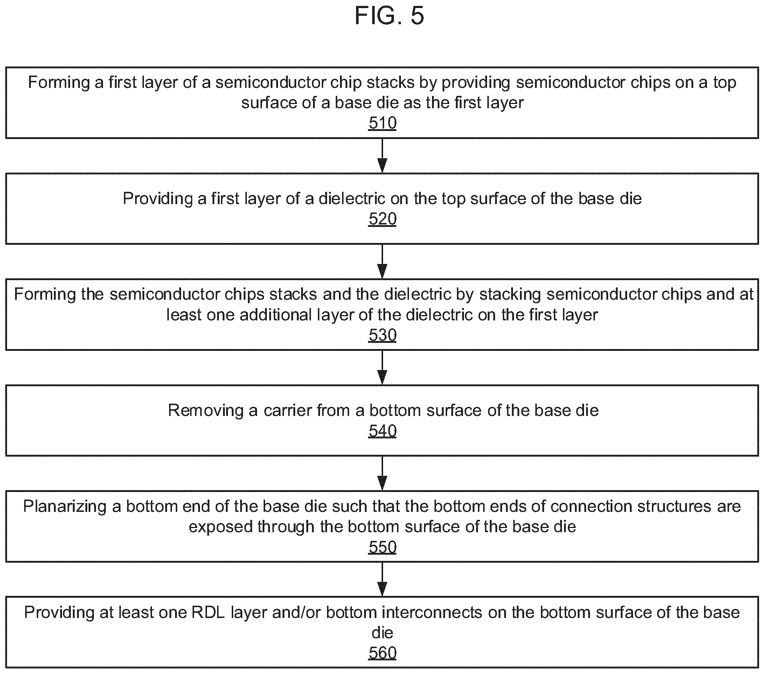

With reference to FIGS. 5-10, a manufacturing process of the semiconductor device 1 is described below.

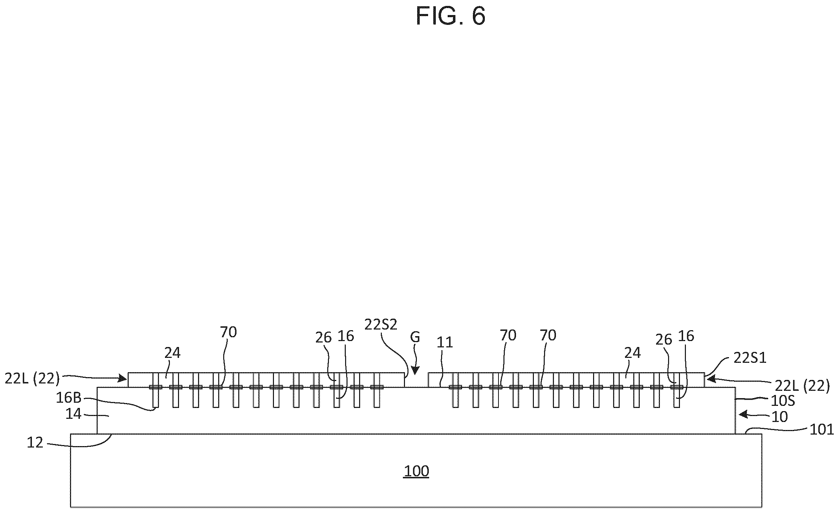

FIG. 5 illustrates a flowchart for a method 500 of manufacturing the semiconductor device 1 according to some example embodiments of the present disclosure. FIGS. 6-10 illustrate intermediate semiconductor devices formed in operations of the method of FIG. 5.

With reference to FIG. 6, the method 500 may include forming a first layer of the semiconductor chip stacks 20 by providing semiconductor chips 22 on a top surface 11 of the base die 10 as the first layer (operation 510). For example, two or more semiconductor chips 22 (or lowermost semiconductor chips 22L), each being a first layer of a respective one of the semiconductor chip stacks 20 to be formed, may be directly bonded to the top surface 11 of the base die 10 (e.g., the body 14 of the base die 10) by a plurality of hybrid bonding structures 70.

As shown in the cross-sectional view of FIG. 6, two semiconductor chips 22 are provided and separated from each other in the first horizontal direction such that a gap G is provided therebetween in the first horizontal direction. However, embodiments of the present disclosure are not limited thereto. For example, three or more semiconductor chips 22 may be provided on the top surface of the base die 10 and may be separated from each other in the first horizontal direction by the gap G or another gap. Alternatively or additionally, two or more semiconductor chips 22 may be provided on the top surface of the base die 10 such as to be separated from each other in the second horizontal direction that crosses (e.g., is perpendicular to) the first horizontal direction by the gap G or another gap. According to some example embodiments of the present disclosure, a plurality of the semiconductor chips 22 may be provided in an array pattern on the top surface of the base die 10.

Outer side surfaces 22S1 of the semiconductor chips 22 may be further inwards of the intermediate semiconductor device than side surfaces 10S of the base die 10. For example, the outer side surfaces 20S of the semiconductor chips 22 may not be coplanar with the side surfaces 10S of the base die 10, such that a space may be provided for first portions 31 of the dielectric 30 to be formed on the base die 10 (to be described below).

Prior to and during the operation 510, a bottom surface 12 of the base die 10 (e.g., the body 14 of the base die 10) may be on a top surface 101 of a carrier 100 for support of the base die 10. The carrier 100 may include, for example, silicon or glass.

The base die 10 (e.g., the body 14 of the base die 10) may include the connection structures 16, and the semiconductor chips 22 (e.g., the body 24 of the semiconductor chips 22) may include the connection structures 26. When the semiconductor chips 22 are provided on the top surface 11 of the base die 10 as the first layer, the connection structures 16 of the base die 10 may be electrically connected to the connection structures 26 of the semiconductor chips 22, constituting the first layer, by the hybrid bonding structures 70 between the base die 10 and the semiconductor chips 22, constituting the first layer. Prior to and during the operation 510, the connection structures 60 may each have a bottom end 16B within the body 14 of the base die 10. For example, a vertical level of the bottom end 16B may be higher than a vertical level of the bottom surface 12 of the base die 10.

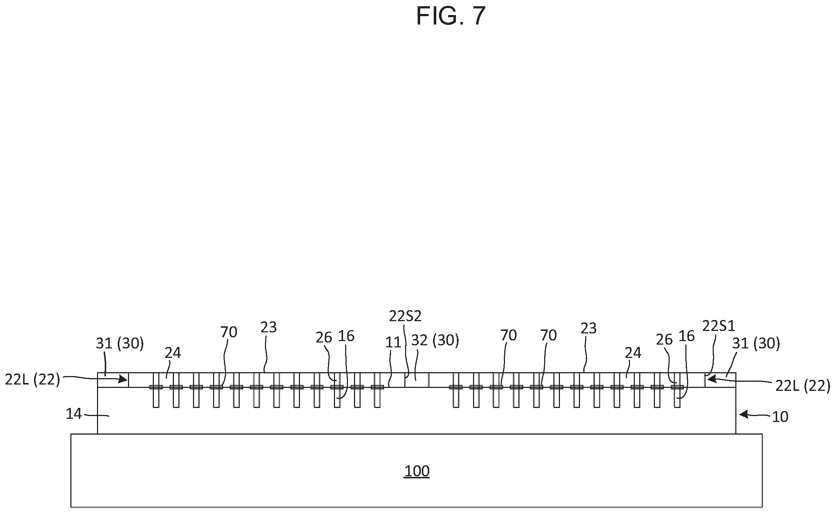

With reference to FIG. 7, the method 500 may further include providing a first layer of the dielectric 30 on the top surface 11 of the base die 10 (operation 520). For example, the first layer of the dielectric 30 may be provided to be in direct contact with the top surface 11 of the base die 10. The first portions 31 may be provided at the outer side surfaces 22S1 of the semiconductor chips 22, constituting the first layer of the semiconductor chip stacks 20 to be formed, towards the outer sides of the intermediate package in at least one horizontal direction (e.g., the first horizontal direction and/or the second horizontal direction). For example, as shown in FIG. 7, one first portion 31 may be provided at a left side of a leftmost one of the semiconductor chips 22, and another first portion 31 may be provided at a right side of a rightmost one of the semiconductor chips 22. The first portion 31 provided at the left side of the leftmost one of the semiconductor chips 22 may be in direct contact with the left side surfaces of the leftmost one of the semiconductor chips 22 and the first portion 31 provided at the right side of the rightmost one of the semiconductor chips 22 may be in direct contact with the right side surface of the rightmost one of the semiconductor chips 22. The first portions 31 may partially or completely cover the outer side surfaces 22S1 of the semiconductor chips 22, constituting the first layer of the semiconductor chip stacks 20 to be formed, that face towards an exterior of the intermediate semiconductor device in at least one horizontal direction (e.g., the first horizontal direction and/or the second horizontal direction).

A thickness of each first portion 31 in the vertical direction may be the same as the thickness, in the vertical direction, of the semiconductor chip 22 that is in direct contact therewith. For example, a thickness of each of the first portions 31 may be 50 µm or less, or 20 µm or less. Also, an upper surface of each first portion 31 may be coplanar with the upper surface 23 of the semiconductor chip 22 that is in direct contact therewith, and a lower surface of each first portion 31 may be coplanar with the lower surface of the semiconductor chip 22 that is in direct contact therewith.

The second portion 32 may be provided within the gap G (see FIG. 6) between inner side surfaces 22S2 of the semiconductor chips 22, that constitute the first layer of the semiconductor chip stacks 20 to be formed, that face towards each other in at least one horizontal direction (e.g., the first horizontal direction and/or the second horizontal direction), and may partially or completely cover the inner side surfaces 22S2 of the semiconductor chips 22. For example, as shown in FIG. 7, the second portion 32 may be between the semiconductor chips 22 that constitute the first layer of the semiconductor chip stacks 20 to be formed. The second portion 32 may be in direct contact with the right side surface of the leftmost one of the semiconductor chips 22 and may be in direct contact with the left side surfaces of the rightmost one of the semiconductor chips 22.

A thickness of the second portion 32 in the vertical direction may be the same as the thickness, in the vertical direction, of the semiconductor chips 22 that are in direct contact therewith. For example, a thickness of the second portion 21 may be 50 µm or less, or 20 µm or less. Also, an upper surface of the second portion 32 may be coplanar with the upper surface 23 of the semiconductor chips 22 that are in direct contact therewith, and a lower surface of each second portion 32 may be coplanar with the lower surfaces of the semiconductor chips 22 that are in direct contact therewith.

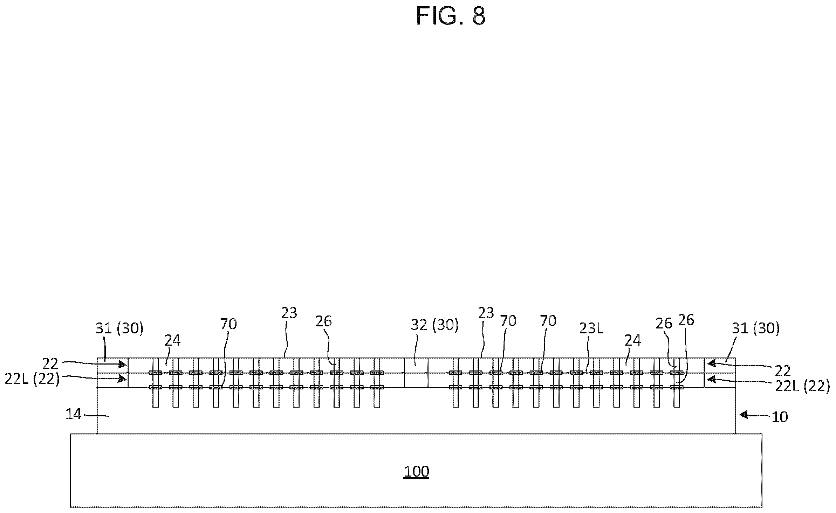

With reference to FIGS. 8-9, the method 500 may further include forming the semiconductor chip stacks 20 and the dielectric 30 by stacking semiconductor chips 22 on the upper surface 23 of the semiconductor chips 22, constituting the first layer of the semiconductor chip stacks 20 to be formed, and by stacking at least one additional layer of the dielectric 30 on the top surface of the first layer of the dielectric 30, respectively (operation 530).

For example, with reference to FIG. 8, the operation 530 may include repeating the operation 510 and then the operation 520 such that semiconductors chips 22, constituting a second layer of the semiconductor chip stacks 20, are stacked on the semiconductor chips 22 constituting the first layer of the semiconductor chip stacks 20, and first portions 31 and a second portion 32, constituting the second layer of the dielectric 30, are stacked on the first portions 31 and the second portion 32 constituting the first layer of the dielectric 30.

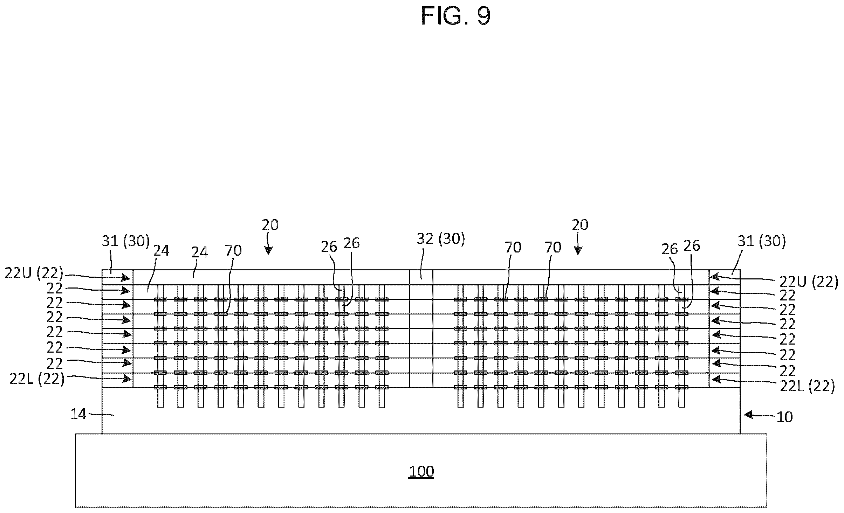

In a case where the semiconductor chip stacks 20 each include more than two semiconductor chips 22, the operation 530 may include repeating the combination of the operation 510 and the operation 520 any number of times until the semiconductor chip stacks 20 and the dielectric 30 are formed. For example, with reference to FIG. 9, the combination of the operation 510 and the operation 520 may be repeated one or more times such that the semiconductor chip stacks 20 and the dielectric 30 each include more than two layers (e.g., 4 layers, 8 layers, 12 layers, etc.). For example, the semiconductor chip stacks 20 may each include eight semiconductor chips 22 that are stacked on each other in the vertical direction, and the dielectric 30 may include eight layers of first portions 31 and second portions 32 that respectively correspond to the eight layers of the semiconductor chips 22 of the semiconductor chip stacks 20. However, embodiments of the present disclosure are not limited thereto. For example, each of the semiconductor chip stacks 20 may include 4, 8, or 12 semiconductor chips that are stacked on each other, and the dielectric 30 may include 4, 8, or 12 layers that are stacked on each other.

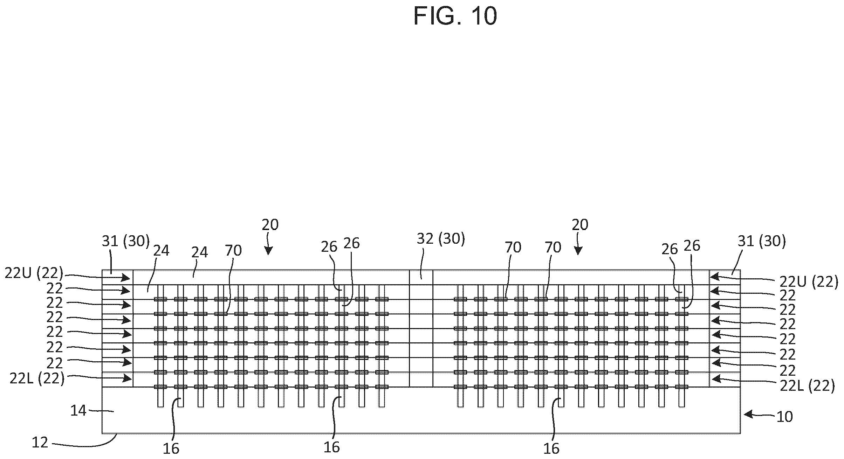

With reference to FIG. 10, the method 500 may further include removing the carrier 100 from the bottom surface 12 of the base die 10 (operation 540). The operation 540 may further include flipping the intermediate semiconductor device up-side down, and applying a second carrier on a top surface (now a bottom surface) of the uppermost semiconductor chips 22U (now lowermost semiconductor chips).

With reference to FIG. 3, the method 500 may further include planarizing (e.g., grinding) the bottom end (a top end when the intermediate semiconductor device is up-side down) of the base die 10 such that the bottom ends of the connection structures 16 are exposed through the bottom surface 12 of the base die 10 (operation 550). The method 500 may further include providing at least one RDL layer 40 on the bottom surface 12 of the base die 10 and/or providing the bottom interconnects 50 on the bottom surface 12 of the base die 10 (operation 560). For example, the at least one RDL layer 40 may be provided on the bottom surface 12 of the base die 10, and the bottom interconnects 50 (e.g., µbumps) may be provided on the bottom surface 42 of the at least one RDL layer 40.

By performing the method 500, the semiconductor device 1 of FIG. 3 may be manufactured.

According to some example embodiments of the present disclosure, a semiconductor device (e.g., the semiconductor device 1) may be provided and include: a first semiconductor chip (e.g., the base die 10); a plurality of semiconductor chip stacks (e.g., semiconductor chip stacks 20) on a top surface of the first semiconductor chip (e.g., the base die 10), the plurality of semiconductor chip stacks (e.g., the plurality of semiconductor chip stacks 20) spaced apart in at least one horizontal direction of the semiconductor device (e.g., the semiconductor device 1) and configured to be electrically connected to the first semiconductor chip (e.g., the base die 10); and a dielectric (e.g., the dielectric 30) on the first semiconductor chip (e.g., the base die 10) and surrounding the plurality of semiconductor chip stacks (e.g., the semiconductor chip stacks 20) in the at least one horizontal direction, wherein each of the plurality of semiconductor chip stacks (e.g., the semiconductor chip stacks 20) includes a plurality of second semiconductor chips (e.g., the semiconductor chips 22) that are stacked on each other in a vertical direction of the semiconductor device (e.g., the semiconductor device 1).

According to some example embodiments of the present disclosure, a method of manufacturing a semiconductor device (e.g., the semiconductor device 1) may be provided. The method may include: forming a first layer of semiconductor chip stacks (e.g., the semiconductor chip stacks 20) on a first semiconductor chip (e.g., the base die 10) by providing second semiconductor chips (e.g., the lowermost semiconductor chips 22L) on a top surface of the first semiconductor chip (e.g., the base die 10) as the first layer; providing a first layer of a dielectric (e.g., the dielectric 30) on the top surface of the first semiconductor chip (e.g., the base die 10) such as to surround the first layer of the semiconductor chip stacks (e.g., the semiconductor chip stacks 20) in at least one horizontal direction of the semiconductor device (e.g., the semiconductor device 1); providing at least one additional layer of the semiconductor chip stacks on the first layer of the semiconductor chip stacks (e.g., the semiconductor chip stacks 20) in a vertical direction of the semiconductor device (e.g., the semiconductor device 1) by stacking at least one additional second semiconductor chip (e.g., the semiconductor chips 22) on each of the second semiconductor chips (e.g., the lowermost semiconductor chips 22L) constituting the first layer of the semiconductor chip stacks (e.g., the semiconductor chip stacks 20), respectively; and providing at least one additional layer of the dielectric (e.g., the dielectric 30) on the first layer of the dielectric (e.g., the dielectric 30) in the vertical direction, wherein the semiconductor chip stacks (e.g., the semiconductor chip stacks 20) are spaced apart in the at least one horizontal direction and are configured to be electrically connected to the first semiconductor chip (e.g., the base die 10), and wherein the dielectric (e.g., the dielectric 30) is on the first semiconductor chip (e.g., the base die 10) and surrounds the semiconductor chip stacks (e.g., the semiconductor chip stacks 20) in the at least one horizontal direction.

According to some example embodiments of the present disclosure, a semiconductor memory device (e.g., the semiconductor device 1) may be provided and include: a computing die (e.g., the base die 10); a plurality of semiconductor memory die stacks (e.g., the semiconductor chip stacks 20) on a top surface of the computing die (e.g., the base die 10) and spaced apart in at least one horizontal direction of the semiconductor memory device (e.g., the semiconductor device 1), the plurality of semiconductor memory die stacks (e.g., the semiconductor chip stacks 20) configured to be electrically connected to the computing die (e.g., the base die 10); and a dielectric (e.g., the dielectric 30) on the computing die (e.g., the base die 10) and surrounding the plurality of semiconductor memory die stacks (e.g., the semiconductor chip stacks 20) in the at least one horizontal direction of the semiconductor memory device (e.g., the semiconductor device 1), wherein each of the plurality of semiconductor memory die stacks (e.g., the semiconductor chip stacks 20) includes a plurality of memory dies (e.g., the semiconductor chips 22) that are stacked on each other in a vertical direction of the semiconductor memory device (e.g., the semiconductor device 1).

According to some example embodiments of the present disclosure, the semiconductor device 1 (e.g., an HBM multi-stack package) and the method 500 of manufacturing the semiconductor device 1 may be provided.

The semiconductor device (e.g., the semiconductor device 1) may include an ultra-thin DRAM core die/dice (e.g., the semiconductor chip 22) with a thickness of about 50 µm or less, or about 20 µm or less, that enables dielectric (e.g., dielectric 30) deposition in a following operation.

The semiconductor device (e.g., the semiconductor device 1) may include die to die stacking and bonding between the DRAM core dies (e.g., the semiconductor chips 22) using hybrid bonding (e.g., the hybrid bonding structures 70), in which copper-to-copper direct bonding is implemented.

The semiconductor device (e.g., the semiconductor device 1) may include dielectric material (e.g., the dielectric 30) to replace a traditional µbump made from metal solder (e.g., copper-tin-copper-SnAg solder, or nickel-gold-solder) with underfill. The dielectric material (e.g., the dielectric 30) may then be deposited after die (e.g., the semiconductor chips 22) placement and then hybrid bonding may be implemented. The thin DRAM core die (e.g., the semiconductor chips 22) may enable thin dielectric (e.g., the dielectric 30) deposition.

Embodiments of the present disclosure may include, for example, the following benefits:
(A) By manufacturing a semiconductor package (e.g., the semiconductor device 1) according to some example embodiments of the present disclosure, a risk of increasing warpage with an increasing size of a semiconductor device (e.g., an HBM) may be mitigated by reducing CTE mismatch between silicon and encapsulation material.
(B) No additional over-molding (e.g., over-molding 930) step may be needed. By adjusting or selecting appropriate dielectric material (e.g., the dielectric 30), warpage of a semiconductor device (e.g., HBM) may be adjustable to meet an overall assembly requirement. For example, some example embodiments of the present disclosure may include the dielectric 30 instead of EMC. That is, some example embodiments may not include EMC for encapsulating the semiconductor chips 22.

Some example embodiments (e.g., the semiconductor device 1) of the present disclosure may be provided on different types of package platforms such as, for example, a standard organic substrate, a silicon interposer, a redistribution layer (RDL) interposer, an embedded silicon bridge, etc. According to some example embodiments of the present disclosure, the semiconductor device 1 may be a component (e.g., a sub-package) of a semiconductor package. According to some example embodiments of the present disclosure, a plurality of the semiconductor device 1 may be provided as components (e.g., sub-packages) of a semiconductor package.

Some example embodiments (e.g., the semiconductor device 1) of the present disclosure may be applied to, for example, AP, CPU, GPU, AI chips and other ASIC, which normally require high power.

According to some example embodiments of the present disclosure, an HBM multi-stack package (e.g., the semiconductor device 1) may be provided that includes multi-layer DRAM stacks (e.g., the semiconductor chip stacks 20) on a computing die (e.g., the base die 10).

According to some example embodiments of the present disclosure, an HBM multi-stack package (e.g., the semiconductor device 1) may be provided that includes a dielectric material (e.g., the dielectric 30) to replace overmolding for warpage control.

According to some example embodiments of the present disclosure, the HBM multi-stack package (e.g., the semiconductor device 1) may be called an HBM twin tower package (or an HBM twin tower) in a case where the HBM multi-stack package includes two semiconductor memory die stacks (e.g., the semiconductor chip stacks 20).

The present disclosure is presented to enable one of ordinary skill in the art to make and use the present disclosure and to incorporate it in the context of particular applications. While the foregoing is directed to specific examples, other and further examples may be devised without departing from the scope of the present disclosure.

Various modifications, as well as a variety of uses in different applications will be readily apparent to those skilled in the art, and the general principles defined herein may be applied to a wide range of embodiments. Thus, the present disclosure is not intended to be limited to the example embodiments presented herein, and is to be accorded the widest scope consistent with the principles and novel features disclosed herein.

In the description provided, numerous specific details are set forth in order to provide a more thorough understanding of the present disclosure. However, it will be apparent to one skilled in the art that the present disclosure may be practiced without necessarily being limited to these specific details. In other instances, well-known structures and devices are shown in block diagram form, rather than in detail, in order to avoid obscuring the present disclosure.

All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Various features are described in the present disclosure with reference to the drawings. It should be noted that the drawings are only intended to facilitate the description of the features. They are not intended as an exhaustive description of the present disclosure or as a limitation on the scope of the present disclosure. In addition, an illustrated example need not have all the aspects or advantages shown. An aspect or an advantage described in conjunction with a particular example is not necessarily limited to that example and can be practiced in any other examples even if not so illustrated, or if not so explicitly described.

Furthermore, any element in a claim that does not explicitly state "means for" performing a specified function, or "step for" performing a specific function, is not to be interpreted as a "means" or "step" clause as specified in 35 U.S.C. §112(f). In particular, the use of "step of" or "act of" in the claims herein is not intended to invoke the provisions of 35 U.S.C. §112(f).

The labels "left," "right," "front," "back," "top," "bottom," "forward," "reverse," "clockwise" and "counter clockwise," if used, have been used for convenience purposes only and are not intended to imply any particular fixed direction. Instead, they are used to reflect relative locations and/or directions between various portions of an object.

While embodiments have been described with respect to circuit functions, the embodiments of the present disclosure are not limited. Possible implementations, may be embodied in a single integrated circuit, a multi-chip module, a single card, system-on-a-chip, or a multi-card circuit pack. As would be apparent to one skilled in the art, the various embodiments might also be implemented as part of a larger system. Such embodiments might be employed in conjunction with, for example, a digital signal processor, microcontroller, field-programmable gate array, application-specific integrated circuit, or general-purpose computer.

For the sake of brevity, conventional elements to semiconductor devices may or may not be described in detail herein. However, even if a certain element is described or illustrated in a semiconductor device in the present disclosure, the element may not be included in a claimed semiconductor device unless the element is recited as being included in the claimed semiconductor device. Also, when a particular method for deposition or etching used in manufacturing a semiconductor device is or is not mentioned herein, it will be understood that a conventional method for such deposition or etching may be applied in corresponding steps of manufacturing the semiconductor device.

## Claims

1. A semiconductor device (1) comprising:
a first semiconductor chip (10);
at least one semiconductor chip stack (20) on a surface of the first semiconductor chip (10) in a first direction of the semiconductor device (1), the at least one semiconductor chip stack (20) configured to be electrically connected to the first semiconductor chip (10); and
a dielectric (30) on the first semiconductor chip (10) in the first direction, and surrounding the at least one semiconductor chip stack (20) in at least one second direction of the semiconductor device (1) that is perpendicular to the first direction,
wherein the at least one semiconductor chip stack (20) comprises at least one second semiconductor chip (22L-22U).

2. The semiconductor device (1) of claim 1, wherein the at least one second semiconductor chip (22L-22U) is a plurality of second semiconductor chips (22L-22U) that are stacked in the first direction.

3. The semiconductor device (1) of claim 2, wherein the semiconductor device (1) further comprises a connection structure (70) that connects the plurality of second semiconductor chips (22L-22U), wherein the connection structure (70) comprises:
an upper embedded metal (72U);
a lower embedded metal (72L) that is connected to the upper embedded metal (72U);
an upper dielectric layer (74U); and
a lower dielectric layer (74L) that is connected to the upper dielectric layer (74U), and
wherein the upper dielectric layer (74U) surrounds the upper embedded metal (72U), and the lower dielectric layer (74L) surrounds the lower embedded metal (72L).

4. The semiconductor device (1) of any one of the previous claims, wherein the semiconductor device (1) further comprises a connection structure (70) that connects the at least one semiconductor chip stack (20) and the first semiconductor chip (10), wherein the connection structure (70) comprises:
an upper embedded metal (72U);
a lower embedded metal (72L) that is connected to the upper embedded metal (72U);
an upper dielectric layer (74U); and
a lower dielectric layer (74L) that is connected to the upper dielectric layer (74U), and
wherein the upper dielectric layer (74U) surrounds the upper embedded metal (72U), and the lower dielectric layer (74L) surrounds the lower embedded metal (72L).

5. The semiconductor device (1) of any one of the previous claims, wherein the at least one second semiconductor chip (22L-22U) comprises a memory device.

6. The semiconductor device (1) of any one of the previous claims, wherein the first semiconductor chip (10) comprises a computing device.

7. The semiconductor device (1) of any one of the previous claims, wherein the at least one semiconductor chip stack (20) is a plurality of semiconductor chip stacks (20).

8. The semiconductor device (1) of any one of the previous claims, wherein the dielectric comprises silicon dioxide, SiO₂, silicon carbon nitride, SiCN, or silicon nitride, SiN.

9. A method (500) of manufacturing a semiconductor device (1), the method (500) comprising:
forming a first layer of at least one semiconductor chip stack (20) on a first semiconductor chip (10), in a first direction of the semiconductor device (1), by providing at least one second semiconductor chip (22L-22U) on a surface of the first semiconductor chip (10) as the first layer;
providing a first layer of a dielectric (30) on the surface of the first semiconductor chip (10) such as to surround the first layer of the at least one semiconductor chip stack (20) in at least one second direction of the semiconductor device (1), perpendicular to the first direction;
providing (530) at least one additional layer of the at least one semiconductor chip stack (20) on the first layer of the at least one semiconductor chip stack (20) in the first direction by stacking, in the first direction, at least one additional second semiconductor chip (22) on the at least one second semiconductor chip (22L-22U) constituting the first layer of the at least one semiconductor chip stack (20); and
providing at least one additional layer of the dielectric (30) on the first layer of the dielectric (30) in the first direction,
wherein the at least one semiconductor chip stack (20) is configured to be electrically connected to the first semiconductor chip (10), and
wherein the dielectric (30) is on the first semiconductor chip (10) in the first direction, and surrounds the at least one semiconductor chip stack (20) in the at least one second direction.

10. The method (500) of claim 9, wherein the providing the first layer of the at least one semiconductor chip stack (20) comprises connecting the at least one second semiconductor chip (22L-22U) to the first semiconductor chip (10) with a connection structure (70),
wherein the connection structure (70) includes:
an upper embedded metal (72U);
a lower embedded metal (72L) that is connected to the upper embedded metal (72U);
an upper dielectric layer (74U); and
a lower dielectric layer (74L) that is connected to the upper dielectric layer (74U), and
wherein the upper dielectric layer (74U) surrounds the upper embedded metal (72U), and the lower dielectric layer (74L) surrounds the lower embedded metal (72L).

11. The method (500) of claim 9 or 10, wherein the providing the at least one additional layer of the at least one semiconductor chip stack (20) comprises connecting the at least one second semiconductor chip (22L-22U) to the at least one additional second semiconductor chip (22) with a connection structure (70),
wherein the connection structure (70) includes:
an upper embedded metal (72U);
a lower embedded metal (72L) that is connected to the upper embedded metal (72U);
an upper dielectric layer (74U); and
a lower dielectric layer (74L) that is connected to the upper dielectric layer (74U), and
wherein the upper dielectric layer (74U) surrounds the upper embedded metal (72U), and the lower dielectric layer (74L) surrounds the lower embedded metal (72L).

12. The method (500) of any one of claims 9 to 11, wherein the at least one second semiconductor chip (22L-22U) and the at least one additional second semiconductor chip (22) include a memory device.

13. The method (500) of any one of claims 9 to 12, wherein the first semiconductor chip (10) includes a computing device.

14. The method (500) of any one of claims 9 to 13, wherein the at least one semiconductor chip stack (20) is a plurality of semiconductor chip stacks (20), and optionally the at least one additional second semiconductor chip (22) is a plurality of additional second semiconductor chips (22).

15. The method (500) of any one of claims 9 to 14, wherein the dielectric includes silicon dioxide, SiO₂, silicon carbon nitride, SiCN, or silicon nitride, SiN.
